# EUROPÄISCHE PATENTSCHRIFT

(11) **EP 3 899 468 B1**
(45) Veröffentlichungstag und Bekanntmachung des Hinweises auf die Patenterteilung: **14.12.2022**
(21) Anmeldenummer: 19790532.6
(22) Anmeldetag: 22.10.2019
(51) Int. Cl.: G01L 9/00, B81C 3/00, C03B 5/02

(54) **VERFAHREN ZUR HERSTELLUNG EINER SENSORANORDNUNG ZUR BESTIMMUNG MINDESTENS EINES DRUCKS EINES FLUIDEN MEDIUMS**
METHOD FOR PRODUCING A SENSOR ARRANGEMENT FOR DETERMINING AT LEAST ONE PRESSURE OF A FLUID MEDIUM
PROCÉDÉ DE FABRICATION D'UN ENSEMBLE DE CAPTEURS SERVANT À DÉFINIR AU MOINS UNE PRESSION D'UN MILIEU FLUIDE

(30) Priorität: 17.12.2018 DE 102018221984
(43) Veröffentlichungstag der Anmeldung: 27.10.2021
(73) Patentinhaber: Robert Bosch GmbH, 70442 Stuttgart (DE)
(72) Erfinder: GOLDHAHN, Clemens, 99867 Gotha (DE); WOLF, Ronny, 98574 Schmalkalden (DE); WENK, Ralf, 99880 Leina (DE); STARK, Tilman, 99817 Eisenach (DE); REINHARDT, Marcel, 99869 Goldbach (DE); BAETZOLD, Lutz, 99848 Wutha-Farnroda (DE)
(86) Internationale Anmeldenummer: PCT/EP2019/078681
(87) Internationale Veröffentlichungsnummer: WO 2020/126160

(56) Entgegenhaltungen:
- EP-A1- 3 088 859
- EP-A2- 2 548 931
- DE-A1-102006 023 724
- DE-B4-102006 023 724
- DE-T5-112017 001 287
- JP-A- 2017 032 389

## Beschreibung

### Stand der Technik

Aus dem Stand der Technik sind zahlreiche Verfahren zur Herstellung einer Sensoranordnung zur Bestimmung mindestens eines Drucks eines fluiden Mediums bekannt. Bei den Vorrichtungen kann es sich dabei insbesondere um mikromechanische Drucksensoren handeln, wie sie beispielsweise aus Konrad Reif (Hrsg.): Sensoren im Kraftfahrzeug, 2. Auflage 2012, Seiten 134-136 bekannt sind.

WO2009/067449 A1 offenbart eine kombinierte Flüssigkeits- und Dampfdruck-Sensoranordnung, umfassend einen Körper und einen Montageabschnitt zum Koppeln des Körpers mit einem Kraftstoffpumpenmodul-Flansch welche eine Grenzfläche zwischen einer Innenseite und einer Außenseite eines Kraftstofftanks definiert. Ein Flüssigkeitsdrucksensor ist in einer Aussparung in dem Körper untergebracht, um einen Flüssigkeitsdruck eines Kraftstoffs in einem Kraftstofftank zu erfassen. Ein Dampfdrucksensor ist in der Aussparung in dem Körper untergebracht, um einen Dampfdruck eines Kraftstoffdampfs in dem Kraftstofftank zu erfassen. Ein elektrischer Verbinder ist mit dem Körper verbunden, um Leistung für den Flüssigkeitsdrucksensor und den Dampfdrucksensor bereitzustellen.

Bisherige Drucksensoren sind üblicherweise so ausgelegt, dass für einen bestimmten Druckbereich ein optimales Ergebnis erzielt wird, beispielsweise für einen Druckbereich von 0 bar bis 100 bar. Weiterhin sind Drucksensoren bekannt, welche für eine Messung von verschieden Druckbereichen ausgelegt sind, indem in einem Sensorgehäuse zwei Drucksensoren verbaut werden und zu denen getrennt die beiden zu messenden Druckbereiche geleitet werden. Eine Weiterentwicklung heutiger Drucksensoren erfordert eine Realisierung größerer Messbereiche. Für ein Verbinden eines Sensorchips mit einer Membran eines Drucksensors kann ein sog. "Seal Glas Prozess" eingesetzt werden. Dabei erfolgt das Aufheizen üblicherweise durch Kontaktwärme.

Trotz zahlreicher Vorteile der aus dem Stand der Technik bekannten Verfahren zur Herstellung einer Sensoranordnung zur Bestimmung mindestens eines Drucks eines fluiden Mediums beinhalten diese noch Verbesserungspotenzial. So weisen die aus dem Stand der Technik bekannten Verfahren üblicherweise lange Temperierungsvorgänge auf. Dies kann zu einer Unwirtschaftlichkeit der entsprechenden Anlagen für einen Großserieneinsatz führen. Weiterhin wird üblicherweise für eine stabile Verbindung und reproduzierbare Kennlinie der Sensoranordnung eine definierte Geometrie der Glasschicht benötigt.

Aus der EP 3 088 859 A1 ist ein Verfahren zur Herstellung einer Sensoranordnung zur Bestimmung mindestens eines Drucks eines fluiden Mediums bekannt, welches die folgenden Schritte umfasst:
a) Bereitstellen eines Sensoranordnungsrohlings, wobei der Sensoranordnungsrohling mindestens einen Druckstutzen umfasst, wobei der Druckstutzen weiterhin mindestens ein Druckverformungselement aufweist, wobei das Druckverformungselement aus mindestens einem induktionsgeeigneten Material hergestellt ist;
b) Aufbringen mindestens eines Glaselements auf eine Oberfläche des Druckverformungselements.

### Offenbarung der Erfindung

Es wird daher ein Verfahren zur Herstellung einer Sensoranordnung zur Bestimmung mindestens eines Drucks eines fluiden Mediums sowie eine Sensoranordnung zur Bestimmung mindestens eines Drucks eines fluiden Mediums vorgeschlagen, welche die Nachteile bekannter Verfahren und Vorrichtungen zumindest teilweise überwinden kann.

In einem ersten Aspekt der vorliegenden Erfindung wird ein Verfahren zur Herstellung einer Sensoranordnung zur Bestimmung mindestens eines Drucks eines fluiden Mediums vorgeschlagen. Das erfindungsgemäße Verfahren kann die Verfahrensschritte, welche im Folgenden beschrieben werden, umfassen. Die Verfahrensschritte können vorzugsweise in der vorgegebenen Reihenfolge durchgeführt werden. Hierbei können ein oder sogar mehrere Verfahrensschritte gleichzeitig oder zeitlich überlappend durchgeführt werden. Weiterhin können einer, mehrere oder alle der Verfahrensschritte einfach oder auch wiederholt durchgeführt werden. Das Verfahren kann darüber hinaus noch weitere Verfahrensschritte umfassen.

Das Verfahren umfasst die folgenden Schritte:
a) Bereitstellen eines Sensoranordnungsrohlings, wobei der Sensoranordnungsrohling mindestens einen Druckstutzen umfasst, wobei der Druckstutzen weiterhin mindestens ein Druckverformungselement aufweist, wobei das Druckverformungselement aus mindestens einem induktionsgeeigneten Material hergestellt ist;
b) Aufbringen mindestens eines Glaselements auf eine Oberfläche des Druckverformungselements;
c) Erfassen mindestens einer Temperatur des Druckverformungselements mittels mindestens eines Pyrometers;
d) Induzieren einer Spannung in dem Druckverformungselement mittels mindestens eines Induktors derart, dass das Glaselement schmilzt und sich eine Glasschicht auf dem Druckverformungselement ausbildet;
e) Aufbringen eines Sensorelements auf die Glasschicht derart, dass sich eine stoffschlüssige Verbindung zwischen dem Sensorelement und der Glasschicht ausbildet.

Das Verfahren kann weiterhin ein Einbringen des Druckstutzens in eine kühlbare Aufnahmevorrichtung und ein Kühlen des Druckstutzens mittels der kühlbaren Aufnahmevorrichtung umfassen.

Unter einer "Sensoranordnung" kann im Rahmen der vorliegenden Erfindung grundsätzlich eine beliebige Vorrichtung verstanden werden, welche den Druck bestimmen kann und welche beispielsweise mindestens ein Messsignal entsprechend des Drucks erzeugen kann, beispielsweise ein elektrisches Messsignal wie beispielsweise eine Spannung oder einen Strom.

Insbesondere kann die Sensoranordnung eingerichtet sein, einen innerhalb eines Druckbereichs liegenden Druck p des fluiden Mediums zu bestimmen, insbesondere zu messen. Beispielsweise kann es sich bei dem Druckbereich um einen Bereich 0 ≤ p ≤ 5000 bar, bevorzugt um einen Bereich 0 ≤ p ≤ 3500 bar, handeln. Insbesondere kann die Sensoranordnung eingerichtet sein, den Druck p innerhalb des genannten Druckbereichs mit einer maximal zulässigen Abweichung des Messergebnisses von dem tatsächlich herrschenden Druck zu bestimmen. Die zulässige maximale Abweichung kann dabei beispielsweise in % des tatsächlich herrschenden Drucks, beispielsweise des Nenndrucks des fluiden Mediums, angegeben werden.

Die Sensoranordnung kann insbesondere zum Einsatz in einem Kraftfahrzeug eingerichtet sein. Beispielsweise kann die Sensoranordnung zum Einsatz in einem Antriebsstrang und/oder einem Getriebe und/oder einem Thermomanagement-System eines Kraftfahrzeugs, beispielsweise eines Elektrofahrzeugs, eingerichtet sein. Auch andere Ausgestaltungsformen und Einsatzgebiete der Sensoranordnung sind jedoch grundsätzlich möglich.

Der Begriff "Rohling" bezeichnet grundsätzlich ein beliebiges Objekt, welches für eine Weiterverarbeitung bestimmt ist. Der Rohling kann daher eine oder mehrere Komponenten aufweisen. Die Komponenten können während der Weiterverarbeitung mit weiteren Komponenten verbunden werden. Alternativ und/oder zusätzlich können ein oder mehrere Komponenten des Rohlings während der Weiterverarbeitung verändert werden, beispielsweise umgeformt werden. Auch andere Vorgänge sind grundsätzlich denkbar.

Unter einem "Druckstutzen" kann im Rahmen der vorliegenden Erfindung grundsätzlich ein Element verstanden werden, welches mindestens zwei Enden aufweist, die durch einen Hohlraum miteinander verbunden sind, beispielsweise ein Rohr, und welches eingerichtet ist, einen Druck mittels eines Fluids, insbesondere durch eine Flüssigkeit und/ oder ein Gas, vorzugsweise mittels des fluiden Mediums, von einem ersten Ende des Druckstutzens an mindestens ein zweites Ende des Druckstutzens zu führen. Insbesondere kann der Druckstutzen dabei eingerichtet sein, Formstabilität aufzuweisen, also seine geometrische Form auch bei Belastung durch den Druck des Fluids beizubehalten. Insbesondere kann der Druckstutzen ein Material umfassen, welches eine höhere Festigkeit aufweist als der durch das fluide Medium aufgebrachte oder aufbringbare Druck. Insbesondere kann der Druckstutzen auch aus einem beliebigen anderen formstabilen Material gefertigt sein.

Der Druckstutzen kann eine längliche Grundform aufweisen. Der Druckstutzen kann mindestens eine Bohrung umfassen, welche sich entlang der Längsachse des Druckstutzens erstreckt. Der Begriff "Bohrung" bezeichnet grundsätzlich eine Vertiefung, insbesondere eine runde Vertiefung, oder einen Durchbruch, welche/r mittels eines rotierenden Werkzeugs hergestellt ist. Bei der Bohrung kann es sich insbesondere um eine Zylinderbohrung handeln. Die Bohrung kann grundsätzlich einen für das fluide Medium zugänglichen Innenraum ausbilden. Weiterhin kann eine Mantelfläche des Druckstutzens ein Gewinde aufweisen zur Befestigung des Druckstutzens an einem weiteren Element.

Der Druckstutzen kann weiterhin mindestens ein erstes Ende und mindestens ein zweites Ende aufweisen. Die Begriffe "erstes Ende" und "zweites Ende" sind als reine Beschreibungen anzusehen, ohne eine Reihenfolge oder Rangfolge anzugeben und beispielsweise ohne die Möglichkeit auszuschließen, dass mehrere Arten von ersten Enden und/oder zweiten Enden oder jeweils genau eine Art vorgesehen sein kann. Weiterhin können zusätzliche Enden, beispielsweise ein oder mehrere dritte Enden vorhanden sein. Insbesondere können das erste Ende und das zweite Ende jeweils Stirnseiten des Druckstutzens umfassen. Das Druckverformungselement kann insbesondere an dem zweiten Ende des Druckstutzens angebracht sein.

Unter einem "Druckverformungselement" kann im Rahmen der vorliegenden Erfindung grundsätzlich ein Bauteil verstanden werden, welches eingerichtet ist, seine Form oder Gestalt unter Einwirkung einer äußeren Kraft, insbesondere eines äußeren Drucks, zu ändern. Es kann daher eine Verformung des Bauteils stattfinden. Bei der Verformung kann es sich insbesondere um eine reversible Verformung handeln. Die Verformung kann insbesondere als eine Längenänderung bzw. Dehnung in Erscheinung treten. Das Druckverformungselement kann daher eingerichtet sein, einen Druck des fluiden Mediums aufzunehmen. Das Druckverformungselement kann daher als Druckaufnehmer bezeichnet werden. Insbesondere kann der Druckaufnehmer mindestens eine, vorzugsweise mehrere, Messoberflächen aufweisen.

Das Druckverformungselement kann mindestens eine Membran umfassen oder als Membran ausgebildet sein. Unter einer "Membran" kann im Rahmen der vorliegenden Erfindung grundsätzlich eine beliebige dünne Trennschicht verstanden werden, welche eine biaxial gespannte Fläche bildet. Beispielsweise kann die Membran derart angeordnet sein, dass sie sich durch den Druck des fluiden Mediums elastisch verformen, also eine reversible Formänderung aufweisen kann. Insbesondere kann eine Ausprägung der Verformung der Membran abhängig sein von dem Druck des fluiden Mediums. Beispielsweise kann die Formänderung der Membranen mit dem Druck des fluiden Mediums korrelieren.

Wie bereits oben ausgeführt, ist das Druckverformungselement aus mindestens einem induktionsgeeigneten Material hergestellt. Unter einem "induktionsgeeignetem Material" kann im Rahmen der vorliegenden Erfindung grundsätzlich ein beliebiges Material verstanden werden, bei welchem ein elektrisches Feld bei Änderung einer magnetischen Flussdichte entsteht. Das induktionsgeeignete Material kann daher auch als elektromagnetisch induktionsgeeignetes Material bezeichnet werden. Das induktionsgeeignete Material kann insbesondere mindestens einen magnetisierbaren Stahl umfassen. Auch andere Materialien sind grundsätzlich denkbar. Das Druckverformungselement und der Druckstutzen können insbesondere einstückig ausgebildet sein.

Der Begriff "Aufnahmevorrichtung" bezeichnet im Rahmen der vorliegenden Erfindung grundsätzlich eine beliebige Vorrichtung, welche eingerichtet ist, ein beliebiges Objekt aufzunehmen, insbesondere derart, dass das Objekt zumindest teilweise von der Vorrichtung umschlossen ist. Die Aufnahmevorrichtung kann daher insbesondere eine Aussparung in einem Innenraum der Aufnahmevorrichtung aufweisen. Weiterhin kann die Aufnahmevorrichtung eine zumindest weitgehend plane Oberfläche aufweisen, damit das Objekt auf der Oberfläche aufliegen kann.

Der Begriff "kühlbare Aufnahmevorrichtung" bezeichnet insbesondere eine Aufnahmevorrichtung, welche derart ausgestaltet ist, dass eine Temperatur der Aufnahmevorrichtung, insbesondere eine Temperatur eines Innenraums der Aufnahmevorrichtung und/oder einer Temperatur des in der Aufnahmevorrichtung aufgenommenen Objekts reduziert werden kann. Die Aufnahmevorrichtung kann daher eine Kühlvorrichtung umfassen oder mit einer Kühlvorrichtung operativ verbunden sein. Der Druckstutzen kann mittels der kühlbaren Aufnahmevorrichtung insbesondere auf eine Temperatur von 10 °C bis 25 °C gekühlt werden.

Durch die kühlbare Aufnahmevorrichtung wird eine stabile Temperaturverteilung im Druckstutzen erreicht. Somit kann eine Regelung vereinfacht werden. Außerdem kann eine Wärmeleitung in andere Bereiche des Sensoranordnungsrohlings vermieden oder zumindest reduziert werden und daraus resultierende Abweichungen können ebenfalls vermieden oder zumindest reduziert werden.

Die kühlbare Aufnahmevorrichtung kann derart ausgestaltet sein, dass das erste Ende des Druckstutzens auf einer Oberfläche der kühlbaren Aufnahmevorrichtung aufliegt. Insbesondere kann die kühlbare Aufnahmevorrichtung eine Durchgangsöffnung, insbesondere eine Durchgangsbohrung, insbesondere eine Druckbohrung, aufweisen. Die Durchgangsbohrung kann derart ausgebildet sein, dass sie sich von einer äußeren Umgebung der kühlbaren Aufnahmevorrichtung zu der Oberfläche der kühlbaren Aufnahmevorrichtung erstreckt. Somit kann eine Temperaturerfassung der Membran mittels des Pyrometers, welches nachfolgend noch näher beschrieben wird, durch die Durchgangsbohrung erfolgen. Die kühlbare Aufnahmevorrichtung kann weiterhin derart ausgestaltet sein, dass mindestens 5 %, vorzugsweise mindestens 10 %, besonders bevorzugt mindestens 20 % einer Länge des Druckstutzens von der kühlbaren Aufnahmevorrichtung umschlossen sind. Der Begriff "Kühlen" bezeichnet grundsätzlich einen beliebigen Vorgang, bei welchem eine Temperatur eines beliebigen Objekts reduziert wird.

Der Begriff "Pyrometer" bezeichnet grundsätzlich ein beliebiges Strahlungsthermometer, welches eingerichtet ist für eine berührungslose Temperaturmessung. Beispielsweise handelt es sich um ein Quotientenpyrometer oder um ein Gesamtstrahlungspyrometer. Das Pyrometer kann insbesondere eine Vorsatzoptik aufweisen. Das Pyrometer kann eingerichtet sein, die Temperatur des Druckverformungselements, insbesondere der Membran, durch die Bohrung der kühlbaren Aufnahmevorrichtung zu erfassen. Das Pyrometer kann daher unterhalb des ersten Endes des Druckstutzens angeordnet sein. Insbesondere kann eine Tiefe der Bohrung größer sein als ein dreifacher Durchmesser der Bohrung. Hierdurch kann sich eine Annäherung an einen idealen schwarzen Strahler ergeben, so dass die Temperatur der Membran direkt auf einer Metalloberfläche des Druckstutzens erfasst werden kann, insbesondere ohne weitere Maßnahmen. Dadurch kann ein Aufbringen des Sensorelements vereinfacht sein, insbesondere ungehindert möglich sein.

Das Glaselement kann insbesondere eine zylindrische Grundform aufweisen. Insbesondere kann das Glaselement einen Durchmesser von 0,5 mm bis 3 mm aufweisen. Weiterhin kann das Glaselement eine Dicke von 5 µm bis 100 µm aufweisen. Das Glaselement kann insbesondere eine Schmelztemperatur von 300 °C bis550 °C aufweisen. Das Glaselement kann hergestellt sein aus mindestens einem Material ausgewählt aus der Gruppe bestehend aus: bleihaltigen oder bleifreien Gläsern mit der angegebenen Schmelztemperatur.

Wie bereits oben ausgeführt, wird das Glaselement auf die Oberfläche des Druckverformungselements aufgebracht. Dies kann beispielsweise durch Drucken einer Glaspaste auf die Oberfläche des Druckverformungselements erfolgen.

Der Begriff "Induktor" bezeichnet grundsätzlich einen beliebigen Überträger eines Stromes aus einem Induktionsgerät in ein Werkstück. Der Induktor kann beispielsweise als Flachspule, Spule oder auch als einzelne Windung ausgebildet sein. Insbesondere kann der Induktor mit einem Hochfrequenzgenerator operativ verbunden sein. Weiterhin kann der Hochfrequenzgenerator operativ mittels eines PID-Reglers mit dem Pyrometer verbunden sein. Der Hochfrequenzgenerator kann eingerichtet sein, den Induktor mit Spannung zu versorgen. Der Induktor kann eine ringförmige Grundform aufweisen. Der Induktor kann daher einen Hohlraum aufweisen. In dem Hohlraum kann der Druckstutzen, insbesondere das zweite Ende des Druckstutzens, angeordnet sein. Insbesondere kann die Membran in dem Hohlraum des Druckstutzens angeordnet sein. Der Induktor kann um die Membran angeordnet sein. Der Induktor kann in einem Abstand von 0,1 mm bis 5 mm zu der Membran angeordnet sein. In die Membran wird durch den Induktor eine Spannung induziert, die zu einer Erwärmung der Membran durch die entstehenden Wirbelströme führt. Dadurch kann sich eine besonders kleine Erwärmungszone ergeben. Neben einer schnellen und effizienten Erwärmung kann sich darüber hinaus eine sehr kurze Regelstrecke ergeben.

Das Erwärmen des Druckverformungselements, insbesondere der Membran, kann eine Aufheizphase, eine Haltephase sowie eine Abkühlphase umfassen. Die Aufheizphase, eine Haltephase sowie die Abkühlphase können parametrisierbar in Kurvenform und Zeit sein. Auf diese Weise ergibt sich grundsätzlich die Möglichkeit, das Verfahren an individuelle Eigenschaften des Glaselements anzupassen. Durch eine Temperaturerfassung in einer unmittelbaren Nähe zu dem Glaselement bzw. zu der Glasschicht kann sich eine stabile Temperierung in einer Haltephase ergeben, wodurch ein erfolgreiches Einsetzen des Sensorelements begünstigt wird.

Die Aufheizphase kann insbesondere einen linearen Anstieg der Temperatur in Abhängigkeit von der Zeit umfassen. Insbesondere kann die Aufheizphase über einen Zeitraum von 0,5 s bis 20 s, vorzugsweise von 1 s bis 10 s erfolgen. Die Haltephase kann insbesondere über einen Zeitraum von 2 s bis 50 s, vorzugsweise von 5 s bis 30 s erfolgen. Während der Haltephase kann die Temperatur in Abhängigkeit von der Zeit zumindest im Wesentlichen konstant sein. Ein Aufheizen der Membran kann auf eine Temperatur von 200 °C bis 900 °C, insbesondere von 300 °C bis 600 °C erfolgen. Während der Haltephase kann die Temperatur in Abhängigkeit von der Zeit daher 200 °C bis 900 °C, insbesondere 300 °C bis 600 °C, betragen. Die Abkühlphase kann insbesondere einen exponentiellen Abfall der Temperatur in Abhängigkeit von der Zeit umfassen.

Unter einem "Sensorelement" kann im Rahmen der vorliegenden Erfindung grundsätzlich ein beliebiges Element mit mindestens einer Sensorfunktion verstanden werden. Insbesondere kann das Sensorelement einstückig ausgestaltet sein und kann beispielsweise als Halbleiterchip oder als keramischer Chip ausgestaltet sein. Das Sensorelement kann daher auch als Sensorchip bezeichnet werden,

Unter einer "formschlüssigen Verbindung" kann im Rahmen der vorliegenden Erfindung grundsätzlich eine beliebige Verbindung von mindestens zwei Elementen verstanden werden, wobei eine Relativbewegung der beiden Elemente zueinander aufgrund der geometrischen Form der mindestens zwei Elemente in mindestens einer Richtung verhindert wird. Beispielsweise können zwei ineinandergreifende Elemente, insbesondere zwei Elemente, welche eine korrespondierende Gestalt oder Form haben, eine formschlüssige Verbindung zueinander aufweisen.

Unter einer "Oberflächenprofilierung" kann grundsätzlich eine beliebige Formgebung einer Oberfläche mittels mindestens eines Musters und/oder mittels mindestens einer Struktur zu verstehen sein. Das Muster kann regelmäßig oder auch unregelmäßig ausgebildet sein. Folglich kann die Oberfläche in einer Querschnittsansicht entsprechend ausgestaltete Erhebungen und Vertiefungen aufweisen. Die Oberflächenprofilierung kann daher auch als Oberflächenstrukturierung oder als Oberflächenstruktur bezeichnet werden. Die Oberflächenprofilierung kann insbesondere mittels mindestens eines Verfahrens, beispielsweise mittels auf einer Lasertechnologie basierenden Verfahrens, hergestellt sein.

Der Begriff "Erzeugen der mindestens einen Oberflächenprofilierung" kann mindestens einen Verfahrensschritt umfassen, bei welchem die Oberflächenprofilierung in die Oberfläche der Membran eingebracht wird. Insbesondere kann die Oberflächenprofilierung in die Oberfläche eingebracht werden, indem Vertiefungen und Erhebungen mittels eines Laserverfahrens eingebracht werden. Das Erzeugen der Oberflächenprofilierung kann daher als Oberflächen-Vorbehandlung bezeichnet werden.

Die Oberflächenprofilierung kann auf mindestens einer Oberfläche der Membran erzeugt werden. Insbesondere kann es sich bei der Oberfläche um eine freie Oberfläche handeln. Unter einer "freien Oberfläche" ist grundsätzlich eine beliebige Oberfläche eines Elements zu verstehen, welche an eine äußere Umgebung des Elements angrenzt. Die freie Oberfläche kann daher auch als Grenzfläche bezeichnet werden. Bei der freien Oberfläche kann es sich somit um eine bearbeitete Oberfläche handeln.

Beispielsweise kann die Oberflächenprofilierung eine Mikroprofilierung und/oder eine Nanoprofilierung sein. Unter dem Begriff "Mikroprofilierung" bzw. "Nanoprofilierung" ist grundsätzlich eine beliebige Oberflächenprofilierung zu verstehen, bei welcher die Erhebungen und/oder Vertiefungen der Oberfläche Abmessungen aufweisen, welche im Bereich von 1 oder mehreren Mikrometern, also im Bereich von 1 µm bis 1000 µm, vorzugsweise im Bereich von 2 µm bis 20 µm, bzw. im Bereich von mehreren Nanometern, insbesondere im Bereich von 10 nm bis 1000 nm, liegen. Bei den Abmessungen kann es sich insbesondere um eine Höhe, eine Breite und/oder eine Tiefe der Erhebungen bzw. der Vertiefungen handeln.

Die Oberflächenprofilierung kann zumindest teilweise eine im Wesentlichen periodische Oberflächenprofilierung sein. Unter dem Begriff "periodische Oberflächenprofilierung" ist im Rahmen der vorliegenden Erfindung grundsätzlich zu verstehen, dass eine Profilierung, insbesondere eine Strukturierung, einer beliebigen freien Oberfläche, auf der freien Oberfläche regelmäßig auftritt und periodisch, d.h. wiederholend in einer wiederkehrenden Reihenfolge, auftritt. Insbesondere kann die Oberflächenprofilierung, wie bereits oben ausgeführt, die Anordnung von Erhebungen und Vertiefungen umfassen, welche auf der freien Oberfläche wiederholend in einer wiederkehrenden Reihenfolge auftreten. Die Anordnung von Erhebungen und Vertiefungen kann eine Einheit bilden und auf der freien Oberfläche können mehrere der Einheiten angeordnet sein. Unter dem Begriff "im Wesentlichen" ist in diesem Zusammenhang zu verstehen, dass zwischen den Erhebungen und Vertiefungen Unregelmäßigkeiten in den Abständen auftreten können. Beispielsweise kann ein Abstand zwischen einer ersten Erhebung und einer ersten Vertiefung eine Abmessung aufweisen, welche um 0,01% bis 0,5% größer oder kleiner ist als eine mittlere Abmessung, welche über eine Vielzahl von Abständen zwischen den Erhebungen und den Vertiefungen der Oberflächenprofilierung gemittelt ist, beispielsweise über mindestens 10 Abständen, vorzugsweise über mindestens 50 Abständen. Weiterhin können Formen der Erhebungen und/oder der Vertiefungen des Musters Abweichungen aufweisen. Beispielsweise kann eine Höhe und/oder eine Breite einer Erhebung bzw. einer Vertiefung eine Abmessung aufweisen, welche um 0,01% bis 0,5% größer oder kleiner ist als eine mittlere Abmessung, welche über eine Vielzahl von Höhen bzw. Breiten, insbesondere über mindestens 10 Höhen bzw. Breiten, vorzugsweise über mindestens 50 Höhen bzw. Breiten, gemittelt ist.

Die Oberflächenprofilierung kann insbesondere eine Vielzahl an Elementen aufweisen. Die Elemente können als Erhebung auf der freien Oberfläche ausgestaltet sein. Insbesondere kann es sich bei den Elementen um isolierte Elemente handeln, welche zu benachbarten Elementen einen Abstand aufweisen. Die Elemente können zueinander berührungsfrei ausgestaltet sein. Alternativ können sich die Elemente zumindest teilweise berühren. Die Elemente können sich von der freien Oberfläche der Membran erstrecken, insbesondere können sich die Elemente quer, vorzugsweise senkrecht, zu der freien Oberfläche der Membran erstrecken.

Die Elemente können insbesondere mindestens eine Form aufweisen ausgewählt aus der Gruppe bestehend aus: einer Säulenform; einer Zylinderform; einer Kegelform, insbesondere einer Kegelstumpfform; einer Tetraederform, insbesondere einer Pyramidenform; einer Prismenform, insbesondere einer Quaderform, insbesondere einer Würfelform. Die Säulenform kann insbesondere eine Grundform aufweisen ausgewählt aus der Gruppe bestehend aus: einer kreisförmigen Grundform, einer quadratischen Grundform, einer quaderförmigen Grundform, einer hexagonalen Grundform. Auch andere Formen sind grundsätzlich denkbar. Mindestens eine Abmessung der Elemente ausgewählt aus der Gruppe bestehend aus: einer Länge, einer Breite, einem Durchmesser, einer Höhe, kann 10 nm bis 800 nm, vorzugsweise 50 nm bis 700 nm betragen.

Folglich kann die Oberflächenprofilierung mindestens eine Struktur aufweisen, ausgewählt aus der Gruppe bestehend aus: einer Säulenstruktur; einer Kegelstruktur, insbesondere einer kegelstumpfförmigen Struktur; einer Pyramidenstruktur, einer Würfelstruktur, einer Streifenstruktur; einer lamellenförmigen Struktur; einer hügelförmigen Struktur; einer kreisfömigen Struktur; einer Gitterstruktur; einer wellenförmigen Struktur; einer riffeiförmigen Struktur.

Weiterhin können die Elemente in mindestens einem Abstand zueinander auf der Oberfläche angeordnet sein. Der Abstand kann beispielsweise 10 nm bis 800 nm, vorzugsweise 50 nm bis 700 nm, besonders bevorzugt 100 nm bis 500 nm, betragen. Alternativ kann der Abstand 1 µm bis 100 µm, vorzugsweise 2 µm bis 20 µm, betragen. Unter dem Begriff "Abstand" ist im Rahmen der vorliegenden Erfindung grundsätzlich eine räumliche Entfernung zwischen zwei oder mehreren Elementen zu verstehen. Insbesondere kann es sich bei dem Abstand um eine Entfernung zwischen zwei Symmetrieachsen der Elemente handeln, wobei sich die Symmetrieachsen senkrecht zu der Oberfläche des Festkörperelektrolyten erstrecken. Weiterhin können die Elemente derart auf der freien Oberfläche des Festkörperelektrolyten angeordnet sein, dass sich zwischen den Elementen Zwischenräume ausbilden. Unter dem Begriff "Zwischenraum" ist grundsätzlich ein beliebiger freier Raum oder ein beliebiges freies Volumen zwischen mindestens zwei Elementen zu verstehen. Insbesondere können die Elemente auf der freien Oberfläche als Erhebungen ausgestaltet sein, und zwischen den Erhebungen können sich die Zwischenräume ausbilden.

In einem weiteren Aspekt der vorliegenden Erfindung wird eine Sensoranordnung zur Bestimmung mindestens eines Drucks eines fluiden Mediums vorgeschlagen, welches hergestellt ist nach einem Verfahren, welches bereits beschrieben wurde oder im Folgenden noch beschrieben wird.

### Vorteile der Erfindung

Das vorgeschlagene Verfahren weist gegenüber bekannten Verfahren zahlreiche Vorteile auf. Das erfindungsgemäße Verfahren kann grundsätzlich einer wirtschaftlichen Umsetzung eines aufgeglasten Sensorelements in Großserie dienen. Erfordernisse wie eine geringe Taktzeit und eine Reduzierung von Anschaffungskosten sowie eine hohe Energieeffizienz können wesentlich besser berücksichtigt werden als mit konventionellen Kontaktwärmeverfahren.

Es wird insbesondere als Alternative zu herkömmlichen Verfahren ein induktives Erwärmungsverfahren mit einer pyrometrischen Temperaturerfassung vorgeschlagen. Das erfindungsgemäße Verfahren kann grundsätzlich konventionelle Kontaktwärmesystem beim sog. "Seal Glas Prozess" ersetzen. Es wird eine pyrometrische Temperaturerfassung auf Metalloberflächen, insbesondere auf blanken Metalloberflächen, eine Temperierung von sehr kleinen Bereichen sowie eine Stabilisierung von Temperaturverteilung im Bauteil zum Erreichen einer Reproduzierbarkeit realisiert.

Es kann eine Erwärmungszeit verringert werden. Dadurch kann ein Wegfall einer Parallelisierung vieler Anlagen erfolgen, wodurch wiederrum eine Serientauglichkeit resultiert. Weiter kann die Regelstrecke verkürzt werden, wodurch eine exaktere Temperaturregelung und Vorgabe von Aufheiz- und Abkühlkurven möglich ist. Weiterhin können ein höherer Wirkungsgrad und eine kleinere Erwärmungszone realisiert werden, woraus grundsätzlich ein geringerer Energiebedarf resultiert.

Durch das Einbringen einer Oberflächenprofilierung kann eine definierte Geometrie des Glases, insbesondere bei der Fertigung von Drucksensoren in Großserie, erzielt werden. Erfordernisse wie eine geringere Taktzeit sowie geringere Kosten sowie eine Möglichkeit zur Einstellung einer kritischen Höhe des Glases können wesentlich besser berücksichtigt werden.

Die resultierende Geometrie der Glas-Schicht lässt sich im Aufschmelzprozess durch die Rohmaterialanordnung und das Oberflächenbenetzungsverhalten steuern. Das Benetzungsverhalten wiederum wird direkt von der Oberflächenstruktur beeinflusst, die vorteilhafterweise durch einen Laser- oder Sandstrahlprozess hergestellt werden kann. Ein Fließverhalten des Glases ist grundsätzlich abhängig von der Strukturierung. So zieht sich das Glas von bestimmten Oberflächen zurück, während es andere Oberflächen stärker benetzt.

Eine definierte Geometrie des aufgeschmolzenen Glases auf der Membran ist somit grundsätzlich kostengünstiger herstellbar, da keine zusätzliche Taktzeit oder Anforderung an Zulieferer notwendig ist. Eine Höhe der Glasschicht kann über ein Zusammenziehen des Glases auf eine kleinere Fläche oder ein stärkeres Verfließen beeinflusst werden. Dies ermöglicht grundsätzlich wirtschaftlichere Prozesse zur Aufbringung des Glases, da eine Zielhöhe nicht unmittelbar erreicht werden muss (beispielsweise einfacher Pastendruck statt mehrfacher Pastendruck mit Zwischentrocknung). Weiterhin ist eine Geometrie flexibel einstellbar und ein Reinigungsprozess als auch ein Pastendruck sind einfacher umsetzbar.

### Kurze Beschreibung der Zeichnungen

Weitere optionale Einzelheiten und Merkmale der Erfindung ergeben sich aus der nachfolgenden Beschreibung bevorzugter Ausführungsbeispiele, welche in den Figuren schematisch dargestellt sind.

Es zeigen:
- Figur 1: eine Prinzipskizze zu einem exemplarischen Ausführungsbeispiel eines erfindungsgemäßen Verfahrens zur Herstellung einer Sensoranordnung;
- Figur 2: einen beispielhaften Temperaturverlauf eines erfindungsgemäßen Verfahrens zur Herstellung einer Sensoranordnung; und
- Figuren 3A -3I: schematische Darstellungen eines Einflusses einer Oberflächenprofilierung auf das erfindungsgemäße Verfahren zur Herstellung einer Sensoranordnung. Ausführungsformen der Erfindung

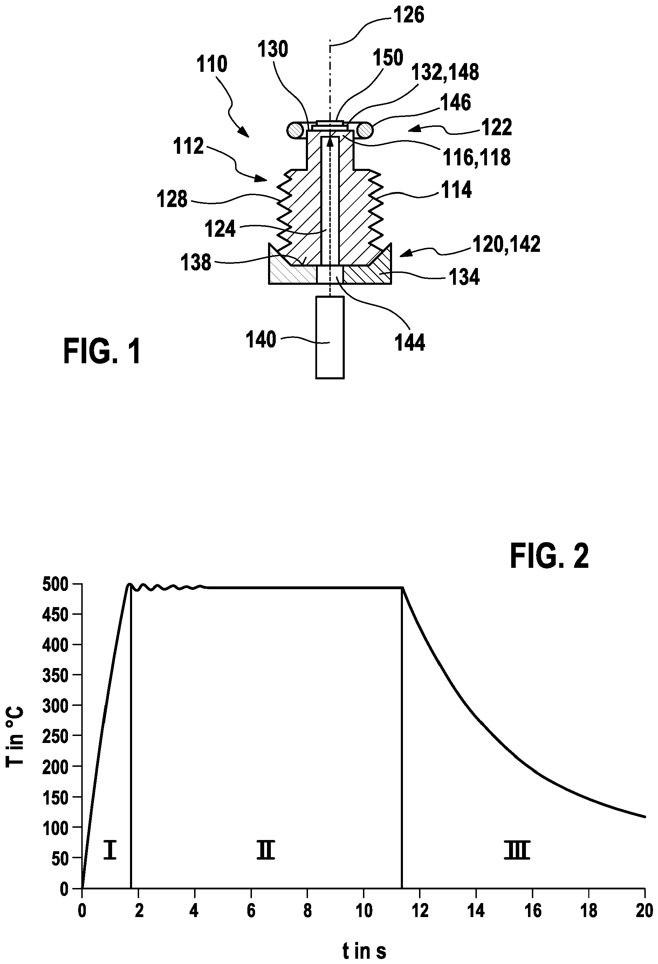

Figur 1 zeigt eine Prinzipskizze zu einem exemplarischen Ausführungsbeispiel eines erfindungsgemäßen Verfahrens zur Herstellung einer Sensoranordnung 110. In einem ersten Schritt wird ein Sensoranordnungsrohling 112 bereitgestellt. Der Sensoranordnungsrohling umfasst einen Druckstutzen 114 sowie ein Druckverformungselement 116. Das Druckverformungselement 116 kann insbesondere als Membran 118 ausgebildet sein. Der Druckstutzen 114 kann ein erstes Ende 120 sowie ein zweites Ende 122 aufweisen. Das Druckverformungselement 116 kann sich am dem zweiten Ende 122 befinden. Insbesondere können das Druckverformungselement 116 sowie der Druckstutzen 114 einstückig ausgebildet sein. Weiterhin kann der Druckstutzen mindestens eine Bohrung 124 aufweisen. Die Bohrung 124 kann sich entlang einer Längsachse 126 des Druckstutzens 114 erstrecken, insbesondere von dem ersten Ende 120 in ein Inneres des Druckstutzens 114. Darüber hinaus kann der Druckstutzen ein Gewinde 128 umfassen. Das Gewinde 128 kann eingerichtet sein, den Druckstutzen 114 an ein anderes Element (nicht darstellt) zu befestigen. Auf eine Oberfläche 130 des Druckverformungselements 116 kann ein Glaselement 132 angebracht werden, beispielsweise durch Kleben. Anschließend kann der Druckstutzen 114 in einer kühlbaren Aufnahmevorrichtung 134 eingebracht werden. Insbesondere kann das erste Ende 120 des Druckstutzens auf einer Oberfläche 138 der kühlbaren Aufnahmevorrichtung 134 aufliegen. Der Druckstutzen 114 kann mittels der kühlbaren Aufnahmevorrichtung 134 gekühlt werden. Eine Temperatur des Druckverformungselements 116 kann mittels eines Pyrometers 140 erfasst werden. Das Pyrometer 140 kann unterhalb einer Stirnseite 142, insbesondere unterhalb dem ersten Ende 120 des Druckstutzens 114 angeordnet sein. Die kühlbare Aufnahmevorrichtung 134 kann eine Durchgangsöffnung 144 aufweisen. Die Temperatur des Druckverformungselements 116 kann daher durch die Bohrung 124 sowie durch die Durchgangsöffnung 144 von dem Pyrometer 140 erfasst werden. Mittels eines Induktors 146 kann eine Spannung in dem Druckverformungselement 116 induziert werden. Der Induktor 146 kann operativ mit einem Hochfrequenz-Generator verbunden sein. Die Spannung kann zu einer Erwärmung des Druckverformungselements 116 bzw. des Glaselements 132 führen, insbesondere durch entstehende Wirbelströme. Der Induktor 146 kann ringförmig, insbesondere kreisringförmig ausgebildet sein und beabstandet zu dem Druckverformungselement 116 angeordnet sein. Das Glaselement 132 kann schmelzen und es kann sich auf dem Druckverformungselement 116 eine Glasschicht 148 ausbilden. Auf die Glasschicht 148 kann ein Sensorelement 150 aufgebracht werden. Es kann sich eine stoffschlüssige Verbindung zwischen dem Sensorelement 150 und der Glasschicht 148 ausbilden.

Figur 2 zeigt einen beispielhaften Temperaturverlauf eines erfindungsgemäßen Verfahrens zur Herstellung einer Sensoranordnung 110. Es ist die Temperatur T in Abhängigkeit einer Zeit t gezeigt. Das erfindungsgemäße Verfahren ist durch eine Aufheizphase I, eine Haltephase II und eine Abkühlphase III gekennzeichnet. Neben einer Solltemperatur (20 °C bis 800 °C) sind die Aufheizphase, die Haltephase und die Abkühlphase grundsätzlich regelungstechnisch parametrisierbar in Kurvenform und Zeit. Auf diese Weise kann das Herstellungsverfahren optimal auf die Individuellen Anforderungen des Glaselements angepasst werden. Durch die Temperaturerfassung in unmittelbarer Nähe zu dem Glaselement ergibt sich grundsätzlich eine stabile Temperierung in der Haltephase, die für ein erfolgreiches Aufbringen des Sensorelements notwendig ist.

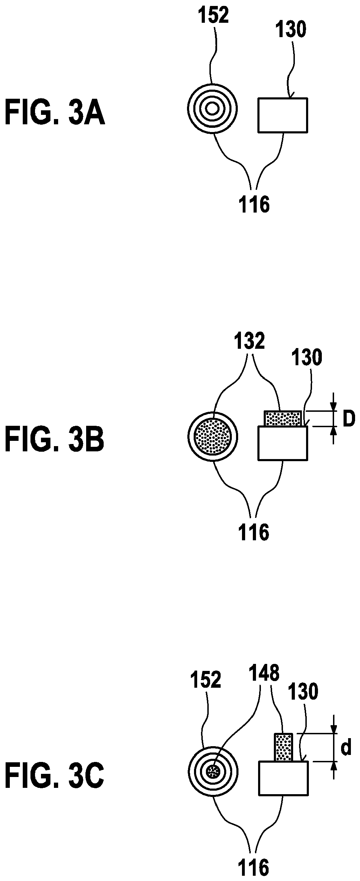

Figuren 3A bis 3I zeigen schematische Darstellungen eines Einflusses einer Oberflächenprofilierung auf das erfindungsgemäße Verfahren zur Herstellung einer Sensoranordnung 110. In allen Figuren sind das Druckverformungselement 116, das Glaselement 132 bzw. die Glasschicht 148 jeweils in einer Draufsicht (linkes Bild) sowie in einer Seitenansicht (rechtes Bild) dargestellt.

Während einer Oberflächen-Vorbehandlung können verschiedene Oberflächenprofilierungen 152, insbesondere mittels eines Lasers, auf der Oberfläche 130 des Druckverformungselements 116 aufgebracht werden. Zusammen mit einer Geometrie des Glaselements 132 können mit einem definierten Temperaturgradienten verschiedene Geometrien und Höhen der Glasschicht 148 erzeugt werden. Bestimmte Geometrien der Glasschicht 148 beeinflussen schlussendlich die Kennlinienparameter und deren Reproduzierbarkeit bei der Sensoranordnung 110. Außerdem ist es nun grundsätzlich möglich, Glasdicken der Glasschicht 148 zu erreichen, die allein durch das Aufbringen des Glaselements 132 nicht möglich sind.

Figur 3A zeigt eine unbehandelte Oberfläche 130 des Druckverformungselements 116. Die kreisringförmige Struktur ergibt sich beispielsweise aus Vorprozessen wie insbesondere Drehprozessen. In Figur 3B wird ein Aufbringen des Glaselements 132 dargestellt. In Figur 3C wird ein Aufschmelzen des Glaselements 132 darstellt, so dass sich auf der Oberfläche 130 eine Glasschicht 148 ausbildet. Die Glasschicht 148 weist eine größere Dicke d auf als das Glaselement 132 (Dicke D), weil sich das Glas aufgrund der Struktur zusammenzieht.

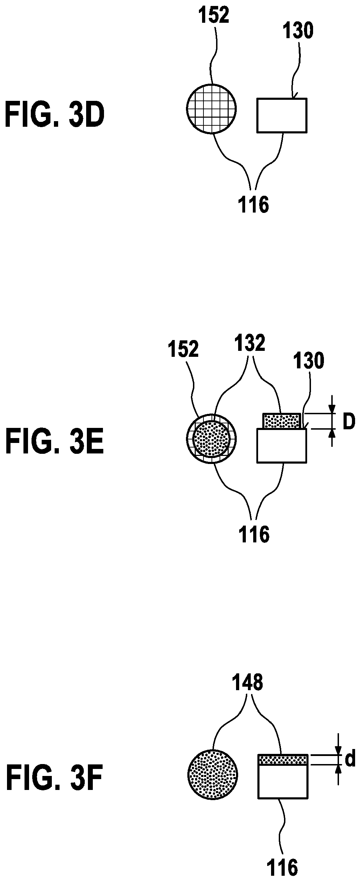

Figur 3D zeigt eine Oberflächen-Vorbehandlung, bei welcher die Oberflächenprofilierung 152 auf die Oberfläche 130 des Druckverformungselements 116 aufgebracht wird. Die Oberflächenprofilierung 152 entspricht einer gitterförmigen Struktur. In Figur 3E wird ein Aufbringen des Glaselements 132 dargestellt. In Figur 3F wird ein Aufschmelzen des Glaselements 132 darstellt, so dass sich auf der Oberfläche 130 eine Glasschicht 148 ausbildet. Die Glasschicht 148 weist eine geringere Dicke d auf als das Glaselement 132 (Dicke D), aufgrund der besseren Anbindung des Glases an diese Oberflächenstruktur.

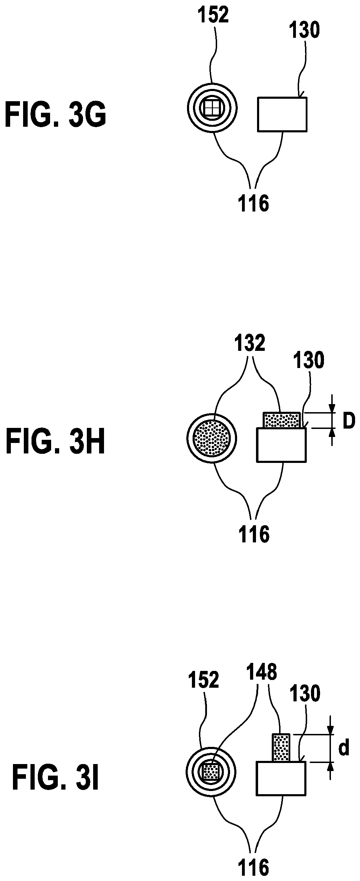

Figur 3G zeigt eine teilweise Oberflächen-Vorbehandlung als Kombination der zuvor gezeigten Varianten, bei welchen eine begrenze Oberflächenprofilierung 158 auf der Mitte der Oberfläche 130 des Druckverformungselements 116 aufgebracht wird. Die begrenzte Oberflächenprofilierung 158 entspricht einer Kombination einer gitterförmigen Struktur sowie der aus Vorprozessen vorhandenen Struktur. In Figur 3H wird ein Aufbringen des Glaselements 132 dargestellt. In Figur 3I wird ein Aufschmelzen des Glaselements 132 darstellt, so dass sich auf der Oberfläche 130 eine Glasschicht 148 ausbildet. Die Glasschicht 148 weist durch den Rückzug von der unbehandelten Oberfläche eine größere Dicke d auf als das Glaselement 132 (Dicke D). Weiterhin ist erkennbar, dass die Glasschicht 148 in Figur 3L in Draufsicht durch die aufgebrachte Strukturierung gelenkt werden kann und nun beispielsweise eine quadratische Grundform aufweist, während die Glasschicht 148 in Figur 3C von alleine zur Bildung runder Grundformen neigt.

## Patentansprüche

1. Verfahren zur Herstellung einer Sensoranordnung (110) zur Bestimmung mindestens eines Drucks eines fluiden Mediums, wobei das Verfahren die folgenden Schritte umfasst:
a) Bereitstellen eines Sensoranordnungsrohlings (112), wobei der Sensoranordnungsrohling (112) mindestens einen Druckstutzen (114) umfasst, wobei der Druckstutzen (114) weiterhin mindestens ein Druckverformungselement (116) aufweist, wobei das Druckverformungselement (116) aus mindestens einem induktionsgeeigneten Material hergestellt ist;
b) Aufbringen mindestens eines Glaselements (132) auf eine Oberfläche (130) des Druckverformungselements (116);
**gekennzeichnet durch** die Schritte:
c) Erfassen mindestens einer Temperatur des Druckverformungselements (116) mittels mindestens eines Pyrometers (140);
d) Induzieren einer Spannung in dem Druckverformungselement (116) mittels mindestens eines Induktors (146) derart, dass das Glaselement (132) schmilzt und sich eine Glasschicht (148) auf dem Druckverformungselement (116) ausbildet;
e) Aufbringen eines Sensorelements (150) auf die Glasschicht (148) derart, dass sich eine stoffschlüssige Verbindung zwischen dem Sensorelement (150) und der Glasschicht (148) ausbildet.

2. Verfahren nach dem vorhergehenden Anspruch, wobei vor Durchführung des Schritts b) mindestens eine Oberflächenprofilierung (152) auf mindestens der Oberfläche (130) des Druckverformungselements (116) erzeugt wird.

3. Verfahren nach dem vorhergehenden Anspruch, wobei die mindestens eine Oberflächenprofilierung (152) ausgewählt ist aus der Gruppe bestehend aus: einer Mikroprofilierung, einer Nanoprofilierung.

4. Verfahren nach einem der beiden vorhergehenden Ansprüche, wobei die Oberflächenprofilierung (152) zumindest teilweise eine im Wesentlichen periodische Oberflächenprofilierung ist.

5. Verfahren nach einem der vorhergehenden Ansprüche, wobei das Verfahren weiterhin ein Einbringen des Druckstutzens in eine kühlbare Aufnahmevorrichtung (134) und Kühlen des Druckstutzens (114) mittels der kühlbaren Aufnahmevorrichtung (134) umfasst.

6. Verfahren nach dem vorhergehenden Anspruch, wobei ein unteres Ende des Druckstutzens (114) mittels der kühlbaren Aufnahmevorrichtung (134) auf eine Temperatur von 5 °C bis 25 °C gekühlt wird.

7. Verfahren nach einem der vorhergehenden Ansprüche, wobei das Glaselement (132) eine zylindrische Grundform mit einer Dicke 5 µm bis 100 µm aufweist.

8. Verfahren nach einem der vorhergehenden Ansprüche, wobei Schritt d) eine Aufheizphase, eine Haltephase und eine Abkühlphase umfasst, wobei die Haltephase über einen Zeitraum von 2 s bis 50 s erfolgt.

9. Verfahren nach einem der vorhergehenden Ansprüche, wobei in Schritt d) ein Aufheizen des Druckverformungselements (116) auf eine Temperatur von 200 °C bis 900 °C erfolgt.

10. Sensoranordnung (110) zur Bestimmung mindestens eines Drucks eines fluiden Mediums hergestellt nach einem Verfahren nach einem der vorhergehenden Ansprüche.

## Claims

1. Method for producing a sensor arrangement (110) for determining at least one pressure of a fluid medium, the method comprising the following steps:
a) providing a sensor arrangement blank (112), the sensor arrangement blank (112) comprising at least one pressure connector (114), the pressure connector (114) furthermore having at least one pressure deformation element (116), the pressure deformation element (116) being produced from at least one material suitable for induction;
b) applying at least one glass element (132) to a surface (130) of the pressure deformation element (116) ;
**characterized by** the steps of:
c) detecting at least one temperature of the pressure deformation element (116) by means of at least one pyrometer (140);
d) inducing a voltage in the pressure deformation element (116) by means of at least one inductor (146) in such a way that the glass element (132) melts and a glass layer (148) forms on the pressure deformation element (116);
e) applying a sensor element (150) to the glass layer (148) in such a way that an integral bond forms between the sensor element (150) and the glass layer (148) .

2. Method according to the preceding claim, wherein, before step b) is carried out, at least one surface profiling (152) is produced on at least the surface (130) of the pressure deformation element (116).

3. Method according to the preceding claim, wherein the at least one surface profiling (152) is selected from the group consisting of: a microprofiling, a nanoprofiling.

4. Method according to either of the two preceding claims, wherein the surface profiling (152) is at least partly a substantially periodic surface profiling.

5. Method according to any of the preceding claims, wherein the method furthermore comprises inserting the pressure connector into a coolable receptacle device (134) and cooling the pressure connector (114) by means of the coolable receptacle device (134).

6. Method according to the preceding claim, wherein a lower end of the pressure connector (114) is cooled to a temperature of 5°C to 25°C by means of the coolable receptacle device (134).

7. Method according to any of the preceding claims, wherein the glass element (132) has a cylindrical basic shape having a thickness of 5 µm to 100 µm.

8. Method according to any of the preceding claims, wherein step d) comprises a heating phase, a holding phase and a cooling phase, wherein the holding phase takes place over a time period of 2 s to 50 s.

9. Method according to any of the preceding claims, wherein in step d) the pressure deformation element (116) is heated to a temperature of 200°C to 900°C.

10. Sensor arrangement (110) for determining at least one pressure of a fluid medium, produced according to a method according to any of the preceding claims.

## Revendications

1. Procédé de fabrication d'un ensemble formant capteur (110) destiné à déterminer au moins une pression d'un milieu fluide, le procédé comprenant les étapes suivantes :
a) fournir une ébauche d'ensemble formant capteur (112), l'ébauche d'ensemble formant capteur (112) comprenant au moins une tubulure sous pression (114), la tubulure sou pression (114) comportant en outre au moins un élément à déformation sous pression (116), l'élément à déformation sous pression (116) étant fabriqué à partir d'au moins un matériau approprié à l'induction ;
b) appliquer au moins un élément en verre (132) sur une surface (130) de l'élément à déformation sous pression (116) ;
**caractérisé par** les étapes suivantes :
c) détecter au moins une température de l'élément à déformation sous pression (116) au moyen d'au moins un pyromètre (140) ;
d) induire une contrainte dans l'élément à déformation sous pression (116) au moyen d'au moins un inducteur (146) de manière à ce que l'élément en verre (132) fonde et à ce qu'une couche de verre (148) se forme sur l'élément à déformation sous pression (116) ;
e) appliquer un élément formant capteur (150) sur la couche de verre (148) de manière à former une liaison de matière entre l'élément formant capteur (150) et la couche de verre (148).

2. Procédé selon la revendication précédente, au moins un profil de surface (152) étant généré sur au moins la surface (130) de l'élément à déformation sous pression (116) avant d'exécuter l'étape b).

3. Procédé selon la revendication précédente, l'au moins un profil de surface (152) étant sélectionné dans le groupe comprenant : un profil micrométrique, un profil nanométrique.

4. Procédé selon l'une des deux revendications précédentes, le profil de surface (152) étant au moins en partie un profil de surface sensiblement périodique.

5. Procédé selon l'une des revendications précédentes, le procédé comprenant en outre l'insertion de la tubulure sous pression dans un dispositif de réception (134) pouvant être refroidi et le refroidissement de la tubulure sous pression (114) au moyen du dispositif de réception (134) pouvant être refroidi.

6. Procédé selon la revendication précédente, une extrémité inférieure de la tubulure sous pression (114) étant refroidie à une température de 5 °C à 25 °C au moyen du dispositif de réception (134) pouvant être refroidi.

7. Procédé selon l'une des revendications précédentes, l'élément en verre (132) ayant une forme de base cylindrique d'une épaisseur de 5 µm à 100 µm.

8. Procédé selon l'une des revendications précédentes, l'étape d) comprenant une phase de chauffe, une phase de maintien et une phase de refroidissement, la phase de maintien étant réalisée sur une durée de 2 s à 50 s.

9. Procédé selon l'une des revendications précédentes, à l'étape d) l'élément à déformation sous pression (116) étant chauffé à une température de 200 °C à 900 °C.

10. Ensemble formant capteur (110) destiné à déterminer au moins une pression d'un milieu fluide générée par un procédé selon l'une des revendications précédentes.
